# EUROPEAN PATENT APPLICATION

(11) **EP 3 915 955 A1**
(43) Date of publication of application: **01.12.2021**
(21) Application number: 20177265.4
(22) Date of filing: 28.05.2020
(51) Int. Cl.: C03C 17/00, C03C 17/30, C08F 2/46, C09D 11/00, C09D 183/04, C23C 16/448, C08F 2/44, C08F 2/52, B44C 5/00, B05D 1/02, B05D 3/14

(54) **METHOD OF PROVIDING A COLOUR COATING ON A DECORATIVE ELEMENT**

(71) Applicant: D. Swarovski KG, 6112 Wattens (AT)
(72) Inventor: Heineman, Michael, 6166 Fulpmes (AT)
(74) Representative: Weal, Emily Teresa

(57) **Abstract**

A method of applying a coloured coating to a decorative element such as a gemstone. The method comprises: providing an ink mixture comprising an ink and an organic carrier, the carrier comprising a polymerisable organic material; arranging the ink mixture and the decorative element in a plasma atmosphere; and allowing the ink mixture to polymerise on a surface of the decorative element to form a polymerised colour coating. The polymerisable organic material may comprise a polymerisable siloxane or a polymerisable oxysilane.

## Description

The invention relates to a method of providing a colour coating on a decorative element such as a gemstone, and to a decorative element coated according to the method.

### Introduction

Decorative elements such as gemstones are typically produced in a wide variety of colours. Where the gemstones are made of glass, additives may be introduced into the glass composition to provide colour throughout the entire bulk of the glass. The additives may be tuned to provide any colour that is desired, and manufacturer often have a catalogue of available colours.

For consistent quality, it is important that all gemstones having a particular colour chosen from the catalogue will have exactly the same colour appearance to an observer. However, when bulk glass is coloured using additives, the size and shape of a gemstone can impact how a colour is perceived by an observer. If gemstones of different sizes use an identical additive composition, they will appear to an observer to show slightly different shades or intensities of the same colour depending on their size and shape. For that reason, the additive mixture must be adapted for different sizes and shapes of gemstone to produce an identical colour effect.

Bulk colouring of glass gives a consistent, intense and durable colour effect that provides a high-quality product. However, it is typically only economical to produce a particular glass composition in a relatively large quantity. For that reason, it is generally unfeasible to produce gemstones of a particular colour, size and shape in small volumes. This means production can be limited to a specific number of colours, and 'bespoke' colours cannot be typically produced in small batches.

It would be desirable to find alternative means of colouring gemstones made from materials such as glass that retains at least some of the benefits of bulk glass colouring, while avoiding at least some of the drawbacks.

### Statements of invention

Against this background, the invention resides in a method of applying a coloured coating to a decorative element. The method comprises: providing an ink mixture comprising an ink and an organic carrier, the carrier comprising a polymerisable organic material; arranging the ink mixture and the decorative element in a plasma atmosphere; and allowing the ink mixture to polymerise on a surface of the decorative element to form a polymerised colour coating.

The polymerisable organic material may comprise a polymerisable silane or a polymerisable siloxane. This may be particularly advantageous if the decorative element is made of a glass such as a silica glass, since the resulting polymerised colour coating may comprise an Si-containing matrix that is particularly compatible with the silica glass.

Preferably, the carrier preferably comprises an organic material having a silane group. For example, the carrier may comprise a silane- or silyl- acrylate, such as 3-(Trimethoxysilyl)propyl methacrylate.

The ink mixture preferably comprises a solution. In particular, the ink mixture may be such that the ink is not in suspension. To this end, the ink may be dissolved in the carrier, or vice versa.

The step of providing the ink mixture may comprises mixing the ink and the carrier. Alternatively, the ink mixture may be provided as a pre-mixed mixture.

The ink may comprise a colour-imparting material, which is preferably an organic compound, and optionally a metal organic compound.

The ink may comprise a polar organic solvent, and the colour-imparting material may be dissolved in the polar organic solvent. The polar organic solvent may comprise an ester derived from a carboxylic acid, preferably a glycol ester.

A volumetric ratio of the ink to the carrier may be between approximately 1:2 and 1:100, preferably approximately 1:4.

The method may comprise aerosolising the ink mixture and arranging the aerosolised ink mixture in the plasma atmosphere.

For example, the step of arranging the aerosolised ink mixture in the plasma atmosphere may comprise providing a plasma chamber, creating a plasma atmosphere inside the plasma chamber, and arranging the aerosolised mixture in the chamber.

The method may comprise aerosolizing the ink mixture using an ultrasonic device and/or an atomizer.

Preferably, the ink mixture is aerosolized so as to produce droplets having a diameter of less than approximately 1 micron. To this end, where an ultrasonic device is used, the method preferably comprises using the ultrasonic device at a frequency of approximately 17 MHz.

The polymerised colour coating may comprise a polymer matrix having ink embedded therein, the polymer matrix being at least partially transparent.

When the polymerisable organic material comprises a polymerisable silane or a polymerisable siloxane, the polymer matrix may comprise a polymer having an oxysilane or a siloxane bond.

The decorative element may comprise a body that is at least partially transparent. The body may comprise a glass, preferably a silica glass.

The decorative element may be a gemstone. The gemstone may be faceted.

The invention also extends to a decorative element made using the method described above.

The invention extends further to a decorative element comprising a body that is at least partially transparent, and a coating on an outer surface of the body. The coating comprises a polymer matrix having ink embedded therein. The polymer matrix preferably comprises a polymer having an oxysilane or a siloxane bond. The decorative element may be a gemstone, and the gemstone may comprise a body made of glass, preferably a silica glass.

### Detailed Description

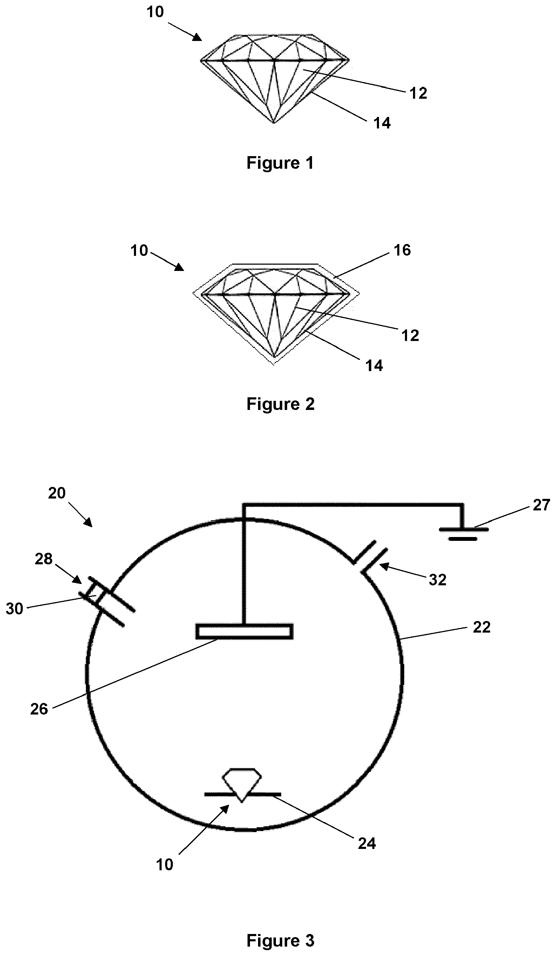

Figure 1 illustrates a decorative element 10: in this example, a faceted gemstone comprising a body 12 made of a substantially colourless glass. Figure 2 illustrates the same decorative element 10 with a coloured coating 14 covering its outer surface 16. The coloured coating 14 is applied over the entire surface, and provides a colour effect, such that even though the body 12 is colourless the gemstone 10 appears coloured. The coloured coating 14 is at least partially transparent, to allow the gemstone to refract light, providing a sparkling appearance.

In this example the body 12 of the gemstone 10 is made of colourless glass, and specifically of a quartz or silica glass comprising up to 85% by weight SiO₂, with other oxide additions. However, in other examples, the glass may be a different glass, for example a borosilicate glass, a borate glass or a phosphate glass. The body 12 of the gemstone 10 may also be made of a coloured glass, so that the colour effect of the coating 14 overlays the colour effect of the body 12 to produce a combined colour effect.

The coating 14 is applied to the gemstone 10 using a plasma-assisted polymerisation method, as will now be described.

First, an ink mixture is created that will act as a precursor material for forming the coating 14. To create the ink mixture, an ink is mixed with an organic carrier material. The ink and the carrier material are dissolved together such that the ink mixture is a solution. This is in contrast to a mixture that is a suspension.

The ink mixture is then aerosolised, and the gemstone 10 and the aerosolised ink mixture are arranged in a plasma atmosphere, for example inside a plasma deposition chamber. The ink mixture is deposited on the surface 16 of the gemstone 10 and polymerises to form the coloured coating 14.

Considering the components of the ink mixture in more detail:
The ink is an organic ink and comprises a colour imparting material, preferably in the form of one or more organic or metal organic compounds, and a polar organic solvent. The organic or metal organic compounds may vary according to the colour of the ink. Any desired colour can be produced by mixing different inks together. The polar organic solvent may be any suitable polar organic solvent, and for example may be an ester of a carboxylic acid, such as glycol ester. A particularly suitable ink is a SB.Gi. 1000, 2000 or 3000 ink commercially available from STS®.

The carrier is an organic material that is capable of polymerisation. In this particular example, the carrier is a silicon-containing polymerisable material, and is specifically a polymerisable silane or siloxane, such as a polymerisable silane- or silyl- acrylate.

For example, the carrier may be 3-(Trimethoxysilyl)propyl methacrylate, commercially available from Merck under designation A174, with the following chemical formula:

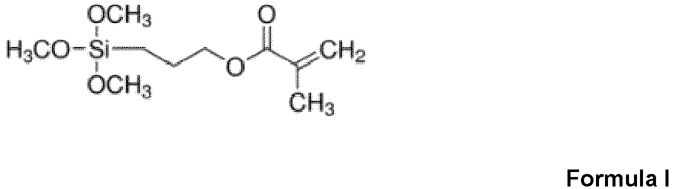

The carrier and the ink are selected such that when the two components are mixed together, they form a solution rather than a suspension. Where the carrier is 3-(Trimethoxysilyl)propyl methacrylate, using an ink based on a polar organic solvent assists in forming the solution. However, it should be appreciated that for different carrier materials, different ink solvents could be appropriate for forming a solution.

The ink and the carrier are mixed in a proportion that is selected to provide the appropriate colour intensity in the deposited colour layer 14. For example, the ratio of the ink to the carrier may be between approximately 1:1 and approximately 1:100, and is preferably approximately 1:4.

The ink mixture is aerosolised using any suitable aerosolization method, for example using an ultrasound device or using a combination of an ultrasound device and an atomiser, such as a Venturi atomiser. Preferably, the aerosolised droplets have a diameter of less than 1 micron: this droplet size is preferred to provide a uniform coating on the gemstone 10. To achieve this droplet size, the ultrasound device is set to a frequency of 1.7 MHz. Where an atomiser is used, an atomisation gas is employed, which may be for example nitrogen or argon.

The plasma-assisted deposition step takes place using a plasma deposition apparatus 20, which is show schematically in Figure 3.

The apparatus 20 is a standard plasma deposition apparatus and comprises a sealable chamber 22 that contains a gemstone support 24 and a carbon electrode 26. The electrode 26 is connected to a voltage supply 27, so that a potential difference can be created between the electrode 26 and the gemstone 10, thereby creating a plasma jet that causes deposition on the surface of the gemstone 10.

A first opening in the chamber 22 defines an inlet 28 through which the aerosolised ink mixture may be introduced into the chamber. Aerosolisation apparatus 30 may be provided in or near the inlet 28 to aerosolise the ink mixture on entry to the chamber 22. The position of the inlet 28 may be optimised, so that the aerosolised ink mixture is fed to an optimum location relative to the plasma jet.

A second opening in the chamber 22 defines an opening 32 through which the chamber 22 may be evacuated and/or through which gases such as argon, nitrogen and oxygen may be introduced into the chamber 22 if required.

To deposit the coloured coating 14 on the gemstone 10, a plasma atmosphere is created in the chamber 22 by creating a potential difference between the gemstone support 24 and the electrode 26. Aerosolised ink mixture is then introduced into the chamber 22 and the plasma stream via the inlet 28. The ink mixture is deposited on the gemstone 10 and polymerises to form the coating.

The energy of the plasma is controlled by tuning the potential difference between the electrode and the holder, and hence by tuning the power supplied to the electrode. In particular, the plasma energy is selected to be sufficiently high that the carrier material can polymerise, but not so high that the organometallic of the ink decomposes, which would otherwise affect the colour of the coloured layer. A power of between 50 W and 500 W is appropriate depending on the exact materials selected for the ink and the carrier material.

When the ink mixture polymerises on the surface of the gemstone, the carrier material forms a polymer matrix that is at least partially transparent. The exact material of the polymer matrix will depend upon the initial carrier material. Where the carrier is a silicon-containing material, the polymer matrix will comprise a polymer that includes silicon. Where the carrier comprises a polymerisable silane or siloxane, the polymer matrix will include a poly-silane or polysiloxane. Where the carrier comprises a polymerisable silyl acrylate, the matrix will comprise a poly silyl- acrylate. A silicon-containing polymer matrix may be particularly compatible with a decorative element that is made of silica glass.

The ink material is trapped within the polymer matrix during polymerisation, and gives the coloured appearance to the coloured layer 14. Because the initial ink mixture was a solution, with ink evenly dissolved in the carrier, the ink material is correspondingly evenly dispersed within the matrix, giving intense, even colour in the coloured layer 14.

Because the coloured layer 14 is a polymer material that has been polymerised directly onto the body 12 of the gemstone 10, the layer 14 has a good adherence to the gemstone 10, and has a high scratch resistance and impact resistance.

The layer therefore provides a consistent and intense colour coating that has good durability. The resulting gemstone therefore gives the appearance of being a coloured gemstone, despite the fact that the body 12 of the gemstone 10 is colourless and the colour is provided only by the coating 14.

By using appropriate ink mixtures, any desired colour can be created on the gemstone 10. The simple plasma-assisted deposition process means that small batches of ink mixture of a particular colour can made and applied to small batches of gemstones in an economic and process. In this way, it is possible to produce small batches of gemstones of bespoke colours in a cost-effective manner.

Although in the embodiments described above the decorative element is a faceted gemstone made of glass, it should be appreciated that the decorative element need not be a faceted gemstone, and need not be made of glass. For example, the decorative element may be a pearl or bead, or a gemstone of a rounded cut such as a cabochon. The decorative element need not be made of glass but may be made of any suitable material for example a ceramic, a glass ceramic, a precious or semi-precious stone, a plastics material, or other suitable materials such as wood.

### Example

An ink mixture was made by mixing an STS ink with a carrier in the form of 3-(Trimethoxysilyl)propyl methacrylate (Merck A174) with an ink : carrier ratio of 1 : 4. The components were mixed until dissolved.

The ink mixture was applied to a glass slide to wet the surface of the slide.

The glass slide was arranged inside a plasma chamber, with the slide at a distance of 85 mm from the plasma source.

A voltage was applied to the plasma source to create a plasma atmosphere inside the chamber. In a first example, the plasma parameters were 13,56 MHz and 800W, and in a second example the plasma parameters were 2,45 GHz and 700W.

In both examples, the mixture polymerized on the glass slide to produce a polymerized colour coating having a uniform colour, with good adhesion to the glass slide.

## Claims

1. A method of applying a coloured coating to a decorative element, the method comprising:
providing an ink mixture comprising an ink and an organic carrier, the carrier comprising a polymerisable organic material;
arranging the ink mixture and the decorative element in a plasma atmosphere; and
allowing the ink mixture to polymerise on a surface of the decorative element to form a polymerised colour coating.

2. The method of Claim 1, wherein the polymerisable organic material comprises a polymerisable silane or a polymerisable siloxane.

3. The method of any preceding claim, wherein the carrier comprises a silane- or silylacrylate.

4. The method of Claim 3, wherein the carrier comprises 3-(Trimethoxysilyl)propyl methacrylate.

5. The method of any preceding claim, wherein the ink mixture comprises a solution.

6. The method of any preceding claim, wherein the ink comprises an organic compound, optionally a metal organic compound.

7. The method of any preceding claim, wherein ink comprises a polar organic solvent.

8. The method of any Claim 7, wherein solvent comprises an ester derived from a carboxylic acid, preferably a glycol ester.

9. The method of any preceding claim, wherein a volumetric ratio of the ink to the carrier is between approximately 1:2 and 1:100, preferably approximately 1:4.

10. The method of any preceding claim, comprising aerosolising the ink mixture and arranging the aerosolised ink mixture in the plasma atmosphere.

11. The method of Claim 10, comprising aerosolizing the ink mixture using an ultrasonic device and/or an atomizer.

12. The method of any preceding claim, wherein the polymerised colour coating comprises a polymer matrix having ink embedded therein, the polymer matrix being at least partially transparent.

13. The method of Claim 12 when dependent on Claim 2, wherein the polymer matrix comprises a polymer having an oxysilane or a siloxane bond.

14. The method of any preceding claim wherein the decorative element comprises a body that is at least partially transparent, and that preferably comprises glass.

15. The method of any preceding claim wherein the decorative element is a gemstone.
